Europäisches Patentamt

**European Patent Office**

**Office européen des brevets**

(11) Veröffentlichungsnummer: **0 007 009**
**B1**

(12) **EUROPÄISCHE PATENTSCHRIFT**

(45) Veröffentlichungstag der Patentschrift: **16.02.83**

(21) Anmeldenummer: **79101890.6**

(22) Anmeldetag: **11.06.79**

(51) Int. Cl.³: **B 41 F 33/02, G 01 R 13/02**

(54) Verfahren zum Anzeigen von Stellgrössen zum Steuern einer Rotationsdruckmaschine.

(30) Priorität: **08.07.78 DE 2830085**

(43) Veröffentlichungstag der Anmeldung:
**23.01.80 Patentblatt 80/2**

(45) Bekanntmachung des Hinweises auf die Patenterteilung:
**16.02.83 Patentblatt 83/7**

(84) Benannte Vertragsstaaten:
**AT BE CH FR GB IT NL SE**

(56) Entgegenhaltungen:
**DE - A - 1 623 783**
**DE - A - 2 141 355**
**FR - A - 2 067 650**
**FR - A - 2 214 130**
**FR - A - 2 394 398**
**US - A - 3 930 447**
**US - A - 3 990 799**
**US - A - 4 008 664**
**US - A - 4 014 011**

(73) Patentinhaber: **Heidelberger Druckmaschinen Aktiengesellschaft**
**Kurfürsten-Anlage 52-60**
**D-6900 Heidelberg 1 (DE)**

(72) Erfinder: **Jeschke, Willi**
**Berghalde 68**
**D-6900 Heidelberg (DE)**
Erfinder: **Rambausek, Hugo**
**Kurpfalzstrasse 6**
**D-6908 Wiesloch (DE)**

(74) Vertreter: **Stoltenberg, Baldo Heinz-Herbert**
**c/o Heidelberger Druckmaschinen AG Kurfürsten-Anlage 52-60**
**D-6900 Heidelberg 1 (DE)**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

Courier Press, Leamington Spa, England.

## Verfahren zum Anzeigen von Stellgrößen zum Steuern einer Rotationsdruckmaschine

Die Erfindung betrifft ein Verfahren zum Anzeigen von Stellgrößen fernbedienter, zonaler Stellglieder zum Dosieren der Farb- und/oder Feuchtführung an einem zentralen Fernsteuerplatz einer Rotationsdruckmaschine, wobei die in Form von elektrischen Stellsignalen rückgemeldeten Stellgrößen in Anzeige-Signale umgewandelt und diese Signale zur optischen Darstellung des Farb- und/oder Feuchteprofils jeweils den Leuchtdioden von getrennten, den einzelnen Farb- und/oder Feuchtzonen zugeordneten Leuchtdiodenreihen zugeführt werden, wobei jede der aufeinanderfolgenden Leuchtdioden innerhalb einer Leuchtdiodenreihe einen anderen Anzeigewert repräsentiert.

Es ist bekannt, im Zuge der weiter fortschreitenden Automatisierungs-maßnahmen an Druckmaschinen der Firma Heidelberger Druckmaschinen AG zur Entlastung des Bedienungspersonals sowie zur Verkürzung der Einrichtezeiten die Farbzonenverstellung zum Verändern der Farbzufuhr mittels den einzelnen Farbzonen eines Farbwerkes zugeordneten Stellgliedern vorzunehmen.

Wie in den "Heidelberger Nachrichten" 3/35, Jahrgang 1977 und in einer anläßlich der "DRUPA" 1977 herausgegebenen Broschüre "Heidelberg Offset CPC" beschrieben, erweist es sich für die Steuerung derartiger Stellglieder als vorteilhaft, das sogenannte Farbprofil am zentralen Fernsteuerplatz der Druckmaschine in Form einer Analoganzeige anzudeuten. Die der jeweiligen Farbschichtdicke der betreffenden Farbzonen entsprechende Lage einzelner aktivierter Leuchtdioden, bezogen auf eine Null-Linie, markiert dabei über die Breite des Fernsteuerplatzes hinweg das sogenannte Farbprofil, das dem Bedienungspersonal eine qualitativ wertvolle Aussage über den momentanen Stand der Farbgebung liefert.

In vielen Fällen, in denen nicht allzu hohe Anforderungen an die Qualität des Druckproduktes gestellt werden, reicht diese relativ genaue Aussage über die Farbgebung aus, insbesondere dann, wenn ohnehin mit einer eingeschränkten Genauigkeit der Rückmeldung der Farbschichtdicke, z.B. infolge eines geringen Auflösungsgrades der Stellgrößen für das Farbprofil gerechnet werden muß, zumal die Erfassung der Stellgröße, wie z.B. die Stellung einer Farbzonenschraube oder die Lage eines bestimmten Punktes am Farbmesser zu einer ortsfesten Koordinate, nicht die tatsächlich vorhandene Farbschichtdicke darstellt.

Die Entwicklung fortschrittlicher, die wirkliche Farbschichtdicke repräsentierender Stellglieder, wie z.B. in der Fernsteuereinrichtung "Heidelberg Offset CPC" realisiert, hat zur Folge, daß die obengenannte Auswertungsmethode zur Erkennung des genauen Farbprofils über die Maschinenbreite nicht mehr ausreicht. Die bessere Reproduzierbarkeit und der mittlerweile erzielbare größere Auflösungsgrad der Stellgrößen für das Farbprofil ermöglichen es, für hinreichende Genauigkeit in der Anzeige zu sorgen, um die Vorteile dieser neuen Steuersysteme optimaler ausnutzen zu können.

Auf die Analoganzeige des Farbprofils kann aber keinesfalls verzichtet werden, da diese für das Bedienungspersonal nach wie vor eine wertvolle Information darstellt, wenngleich sie auch für die Einstellung der Farbgebung einzelner bestimmter Farbzonen, insbesondere bei hohen Güteanforderungen an die Farbqualität des Druckproduktes, einen ungenügenden, wenn auch nicht zu vernachlässigenden Beitrag liefert. Eine Erhöhung der Anzahl der einzelnen zonalen Leuchtdioden ist naheliegend, kann jedoch auch keine Abhilfe schaffen, da z.B. selbst eine Verdoppelung der Anzahl der Leuchtdioden nicht für die geforderte Anzeigengenauigkeit ausreicht, zumal der dazu benötigte Platzbedarf am zentralen Fernsteuerplatz meistens nicht vorhanden ist. Einer Vervielfachung der Genauigkeit der vorhandenen Analoganzeige zum Ablesen von Dezimalen der bisherigen Anzeigewerte sind somit räumlich Grenzen gesetzt.

Des weiteren ist aus der FR—A—2 214 130 eine kontinuierlich fortlaufende Leuchtbalkenanzeige bekannt, bei der die Größe des anzuzeigenden Wertes proportional ist der Länge des Leuchtbalkens, so daß mit zu- bzw. abnehmendem Wert sich der Leuchtbalken entsprechend vergrößert bzw. verkleinert. Da sämtliche Leuchtdioden, ausgehend vom Nullwert bis zum jeweils anzuzeigenden Größenwert, gemeinsam ‚kontinuierlich aufleuchten, können sie nicht noch gleichzeitig für weitere Wertdarstellungen bzw. für eine zusätzliche Anzeigefunktion herangezogen werden. Um eine möglichst genaue Wertdarstellung zu erzielen, wird neben einem Grundsignal hilfsweise ein zweites alternatives Anzeigesignal geschaffen, dessen Amplitude einem Zwischenwert zweier aufeinanderfolgender Leuchtdioden der Leuchtbalkenanzeige entspricht und das auf das Grundsignal addiert wird, um somit auch einen Wert anzeigen zu können, der zwischen zwei Leuchtdioden liegt. Diese Anzeige erfolt mittels Helligkeitsänderungen der jeweils zu oberst aktivierten Leuchtdiode des Leuchtbandes in Relation zu den vorangehenden.

In ähnlicher Weise wird bei der Einrichtung der US—PS 4 014 011 mittels einer Kombination der Leuchtintensitäten jeweils zweier aufeinanderfolgender Leuchtdioden eines Anzeigedisplays anhand zweier differenter Ausgangssignale eine Halbwertanzeige, bestenfalls eine Viertelwertanzeige angestrebt. Zwischenwertanzeigen mittels Helligkeitsänderungen von Leuchtdioden sind ungenau und unzuverlässig, da sich Änderungen in der Leuchtintensität aufgrund erheblicher bauteilbedingter Toleranzen nicht nur der Leuchtdioden, sondern auch der schaltenden Bauelemente und aufgrund des stufenlosen Spannungsanstieges bei allen Leuchtdiodenanzeigen als unerwünschte Nebenwirkung von alleine ergeben. Nähert sich z.B. der anzuzeigende Wert dem Schwellwert der Leuchtdiode, so glimmt diese schon vorher auf und erst beim Erreichen des Schwellwertes selbst leuchtet sie mit voller Intensität. Aufgrunddessen ist bei der Verwendung von Leuchtdioden zur Anzeige — natürlich in Abhangigkeit von deren Ansteuerung und vom Spannungsverlauf des anzuzeigenden Signals — ohnehin bereits eine relativ grobe Zwischenwertanzeige gegeben. Das menschliche Auge vermag jedoch alleine aus Helligkeitsunterschieden keine Absolutwerte abzulesen, zumal die erwähnten Störfaktoren den Helligkeitsgrad der Leuchtdiode beeinflussen.

Da außerdem bei den bekannten Anordnungen jeweils nur eine einzige Leuchtdiode — entweder die zuletzt aktivierte oder die dieser ummittelbar benachbarte — Zwischenwertanzeige herangezogen wird, hat dies eine relativ geringe Feinunterteilung an Zwischenwerten für die Feinanzeige zur Folge.

Ausgehend von diesem Stand der Technik besteht die Aufgabe der Erfindung darin, zusätzlich zu der bereits vorhandenen Analoganzeige des Farb- und/oder Feuchteprofils ein Verfahren und eine Vorrichtung für eine Feinanzeige mit hohem Auflösungsvermögen zu schaffen, die mit geringem Aufwand eine weitere genaue Restinformation über den Feineinstellzustand der Farb- und/oder Feuchtgebung der einzelnen Farb- und/oder Feuchtzonen liefert und diese dem Bedienungspersonal präzise und leicht erfaßbar anzeigt, so daß die Information über eine optimale Farbgebung komplett ist.

Die derart gestellte Aufgabe wird, ausgehend von dem Verfahren gemäß Oberbegriff des Anspruches 1 erfindugsgemäß dadurch gelöst, daß aus denselben Stellsignalen die Anzeigesignale für eine Wertdarstellung in zwei wertmäßig unterteilten, jedoch räumlich identischen Anzeigen, von denen die eine als Grobanzeige und die andere als hochaufgelöste Feinanzeige dient, gewonnen werden, und zwar derart, daß alle jeweils innerhalb einer Leuchtdiodenreihe aufeinanderfolgenden Leuchtdioden nicht nur die verschiedenen Werte der Grobanzeige, sondern auch Zwischenwerte zwischen dem durch die betreffende Leuchtdiode aufgezeigten Wert der Grobanzeige und dem nächst höheren, nicht angezeigten Wert dieser Grobanzeige anzeigen, wobei jeder Leuchtdiode dieser Reihe ein anderer Zwischenwert zugeordnet ist.

Dieses Anzeigeverfahren macht sich die bereits vorhandene gesamte Leuchtdiodenanzeige sowohl zur Grob — als auch zur Fein-Darstellung des Farbprofiles zunutze, wodurch sich trotz der kostensparenden Zusammenlegung der beiden Anzeigen mit geringem technischen Aufwand nicht nur eine analoge Grundinformation über die Anzeige des Farb- und/oder Feuchteprofils erzielen, sondern gleichzeitig in digitaler Form auch die dem Auflösungsgrad und der Reproduzierfähigkeit der Stellglieder gerade noch zugängliche Restinformation für eine Feineinstellung der einzelnen Farb- und/oder Feuchtzonenglieder gewinnen läßt und gezielte Eingriffe in Form von Feinkorrekturen in der Farb- und/oder Feuchtführung zwecks Erzielen einer guten Druckqualität innerhalb kürzester Zeit vorgenommen werden können.

Um eine klare Trennung zwischen der Grob- und der Feinanzeige zwecks guter Übersichtlichkeit beim Ablesen zu erzielen, erfolgt in Weiterbildung der Erfindungsgedankens die analoge Grobanzeige durch konstantes Aufleuchten und die digitale Feinanzeige gleichzeitig durch impulsartiges Blinken einer einzelnen oder gleichzeitig jeweils zweier aufeinanderfolgender Leuchtdioden einer Leuchtdiodenreihe.

Eine Möglichkeit zur vorteilhaften Durchführung des erfindungsgemäßen Verfahrens besteht darin, daß ein Wertungsschritt der Grobanzeige von einer der Leuchtdioden zur nächstfolgenden Leuchtdiode jeweils einer Leuchtdiodenreihe in so viele Feinwerte unterteilt ist, wie insgesamt Leuchtdioden in einer leuchtdiodenreihe der Grobanzeige vorhanden sind. Durch die gleichzeitige Verwendung der Leuchtdiodenreihen sowohl zur Grob- als auch zur Feinanzeige erübrigt sich eine zusätzliche separate Anzeige nebst zugehöriger Schaltelektronik gänzlich. Eine erhebliche Kostenersparnis ist die Folge.

In weiterer Ausgestaltung des erfindungsgemäßen Verfahrens sind zur Feinanzeige die Zwischenwerte dezimal auf die Leuchtdioden einer zonalen Leuchtdiodenreihe aufgeteilt, wodurch eine hohe Anzeigegenauigkeit der Stellgrößen und dadurch große Einstellgenauigkeit der zonalen Stellglieder erzielt wird.

Um höchsten Güteanforderungen an die Druckqualität gerecht zu werden, besteht die Möglichkeit, zur Erhöhung des Auflösungsvermögens der Feinanzeige gleichzeitig mehrere aufeinanderfolgende Leuchtdioden einer Leuchtdiodenreihe anzusteuern.

Weitere vorteilhafte Ausgestaltungen des Erfindungsgedankens sind in der nachfolgenden Beschreibung niedergelegt.

Die Erfindung wird im folgenden in Form einer ausschnittsweise in den Zeichnungen dargestellten Grundausführung sowie anhand eines Ausführungsbeispieles einer Anzeigevorrichtung für die Farbführung näher erläutert.

Es zeigt:

Fig. 1 ein Blockschaltbild einer Grundausführung einer erfindungsgemäßen Anzeigevorrichtung,

Fig. 2 eine ausschnittsweise Darstellung der Grundausführung gemäß Fig. 1, und

Fig. 3 eine ausschnittsweise Darstellung einer weiteren Ausführungsform der Anzeigevorrichtung.

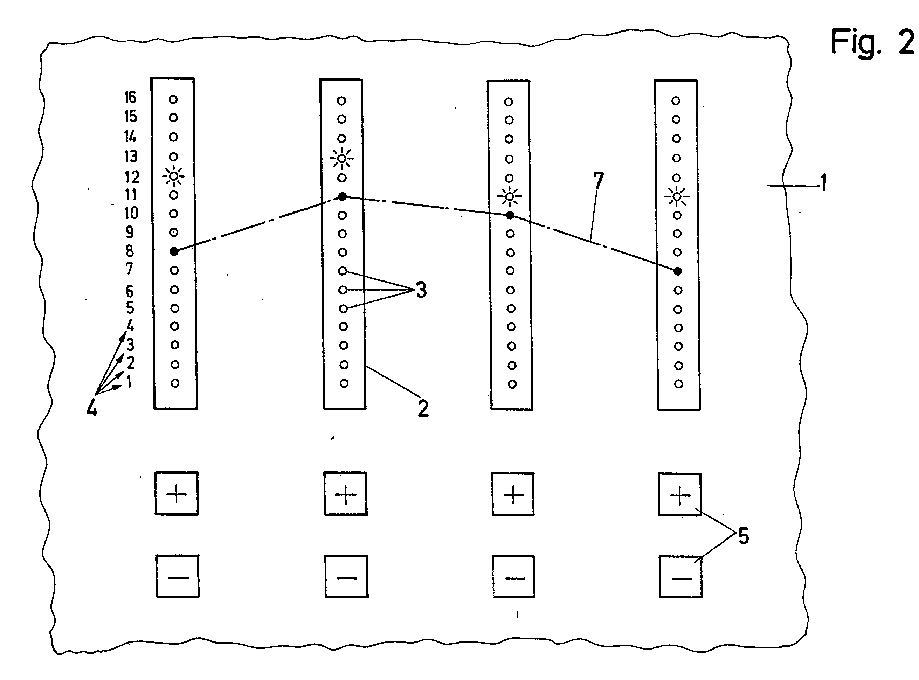

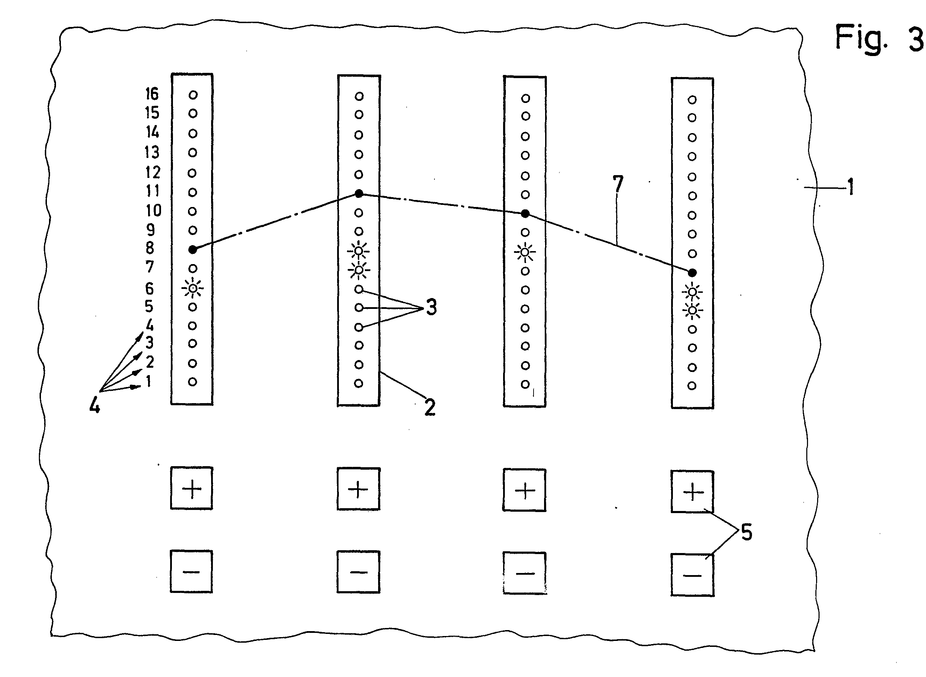

Auf einem Steuertisch 1 eines zentralen Fernsteuerplatzes sind entsprechend der Anzahl der einzelnen Farbzonen eines nicht näher dargestellten und beschriebenen Farbwerkes zonale Leuchtdiodenanzeigen in Form vertikaler Leuchtdiodenreihen 2 angeordnet, wobei jeder Farbzone eine entsprechend der gewünschten Anzeigegenauigkeit große Anahl von Leuchtdioden 3 mit steigenden Ordnungsnummern 4 zugeordnet sein kann. Gemäß den Fig. 2 und 3 besteht eine vertikale Leuchtdiodenreihe 2 aus jeweils sechzehn übereinander angeordneten einzelnen Leuchtdioden 3.

Unterhalb der Leuchtdiodenreichen sind Bedienungselemente in Form von Tasten 5 angeordnet, mit denen der Steuerbefehl für eine Verringerung oder Erhöhung der zonalen Farbmengen ausgelöst werden kann.

Die Fig. 2 stellt einen Ausschnitt aus dem Steuertisch 1 des zentralen Fernsteuerplatzes für die Farbzonenverstellung auszugsweise über einen Bereich von vier Farbzonen dar. Die Verbindung der Leuchtpunkte aller aktivierter Leuchtdioden 3 markiert über die Breite des Steuertisches 1 hinweg das Farbprofil 7 als qualitative Grobaussage über die tatsächlich vorhandene momentane Farbgebung. In der dargestellten Grundausführung mit je sechzehn vertikalen Leuchtdioden 3 pro Farbzonenanzeige wird das Farbprofil 7 von links nach rechts durch die achte, elfte, zehnte und siebte Leuchtdiode 3 markiert. Somit ist das Farbprofil in dem dargestellten Ausschnitt hinreichend bestimmt.

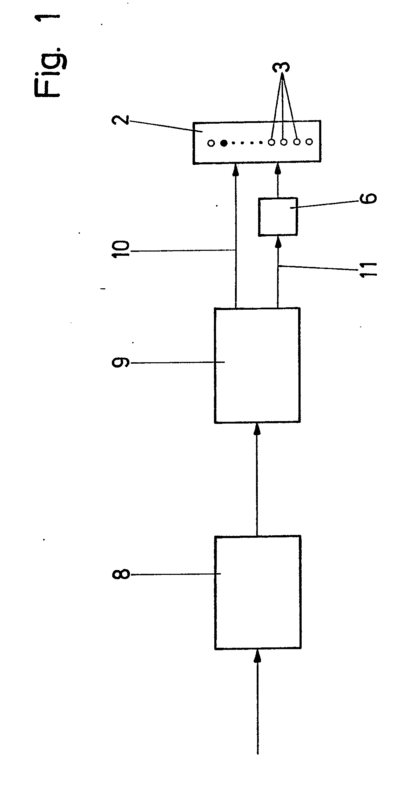

Wie im Blockschaltbild der Fig. 1 schematisch dargestellt, wird die zu messende Stellgröße mittels eines Gebers 8, z.B. ein allgemein gebräuchliches Potentiometer, direkt erfaßt und von diesem einem nachgeschalteten Signalwandler 9, in diesem Fall ein Analog-Digitalwandler, als analoges Eingangssignal zugeführt. Der Signalwandler 9 setzt den Analogwert des Eingangssignals in einen entsprechenden, zur Anzeige verwendbaren Digitalwert um. Unmittelbar vom Signalwandler 9 gehen parallel zueinander Signalpfade 10 und 11 für eine Grobanzeige und eine hochaufgelöste Feinanzeige ab. Die Anzeigesignale werden, je nach deren Wert, alleine der Grobanzeige oder zusätzlich auch der Feinanzeige zugeführt, die beide einen geweils unterschiedlichen Auflösungsgrad ausweisen.

Wenn der Wert des Anzeigesystems im Bereich zwischen unterer und oberer Ansprechschwelle einer der Leuchtdioden 3 einer zonalen, vertikalen Leuchtdiodenreiche 2 liegt, wird dieses Anzeigesignal in der Grobanzeige durch Aktivieren einer Leuchtdiode 3 sichtbar. Durch das simultane Aufleuchten je einer Leuchtdiode 3 verschiedener Zonen ergibt sich eine analoge Darstellung für das Farbprofil. Entsprechend dem Auflösungsgrad für dieses Anzeigesignal, der durch die Größe des Bereiches innerhalb der Ansprechschwellen der Leuchtdioden 3 bestimmt ist, liefert dieses Signal eine Grobinformation.

Über die Zwischenwerte des Signals innerhalb der Ansprechschwellen einer Leuchtdiode 3 gibt die jeweils für die Grobanzeige aktivierte Leuchtdiode 3 keine Auskunft. Um diese Zwischenwerte zusätzlich zur Grobinformation zur Anzeige zu bringen, wird die zusätzliche Feinanzeige benutzt. Eine Vereinfachung zur Durchführung des Anzeigeverfahrens ergibt sich dabei dadurch, daß die für die Grobanzeige des Farbprofils 7 bereits vorhandenen Leuchtdioden 3 gleichzeitig auch für die Feinanzeige ausgenutzt werden, so daß sich eine zusätzliche Anzeige vollkommen erübrigt. Dabei wird der die untere Ansprechschwelle einer Leuchtdiode 3 überschreitende Wert — der niederwertige Teil — des Anzeigesignals über den Anzeigepfad 6 zur Feinanzeige gebracht. Der Auflösungsgrad dieser digitalen Feinanzeige ist erheblich größer als der der analogen Grobanzeige für das Farbprofil.

Wie in Fig. 2 angedeutet, wird die Anzeige derart durchgeführt, daß die für die analoge Grobanzeige des Farbprofils 7 entsprechend der angefahrenen Stellung des Stellgliedes aktivierte Leuchtdiode 3 mit gleicher Intensität dauernd glimmt, während eine weitere Leuchtdiode 3 derselben Leuchtdiodenreihe 2 mit anderer Ordnungsnummer 4 durch impulsartiges Blinken oder durch schwächeres Glimmen, d.h. Aufleuchten mit geringerer Intensität, die zusätzliche Information für die Stellgrößen feineinstellung in digitaler Form liefert.

So bedeutet z.B. ein konstantes Aufleuchten der achten Leuchtdiode 3 und ein impulsartiges Blinken der zwölften Leuchtdiode 3 in der ersten Leuchtdiodenreihe 2 von links, daß das Stellglied für die zugeordnete Farbzone um den Wert 12/16 über den unteren Ansprechwert der achten Leuchtdiode 3 hinaus geöffnet ist.

In dam Sonderfall, in dem ein Grobanzeigewert mit einem Feinanzeigewert auf ein und dieselbe Leuchtdiode 3 zusammenfällt, besteht die Möglichkeit, diese Leuchtdiode 3 zur besseren Abhebung gegenüber den jeweils aktivierten Leuchtdioden 3 der benachbarten Leuchtdiodenreihen 2 diskontinuierlich stärker aufleuchten zu lassen. Da der Zusammenfall dieser zwei Anzeigewerte jedoch ohnehin den nur einzig möglichen Sinderfall darstellt, ist diese Unterscheidung in der Leuchtintensität der Leuchtdioden 3 nicht unbedingt erforderlich, da der Bedienungsmann im Verhältnis zu den benachbarten Leuchtdiodenreihen 2, in denen im Normalfall jeweils zwei Leuchtdioden 3, der Fein- und der Grobwert, aufleuchten, sofort daraus schließen kann, daß hier der nur einzig mögliche Sonderfall der absolut räumlichen Identität von Grob- und Feinanzeigewert vorliegt.

Ein in Fig. 3 dargestelltes Ausführungsbeispiel der Anzeigevorrichtung zeigt im Prinzip den gleichen Aufbau wie das zuvor beschriebene der Fig. 2, wobei die analoge Grobanzeige des Farboprofils 7 ebenfalls in gleicher Weise erfolgt.

Der wesentliche Unterschied dieses Ausführungsbeispiels gegenüber der Grundausführung besteht a ber darin, daß der Auflösungsgrad der digitalen Feinanzeige durch die Möglichkeit der Ansteuerung entweder einer oder gleichzeitig zweier aufeinanderfolgender Leuchtdioden 3 einer Leuchtdiodenreihe 2 verdoppelt worden ist. Das gleichzeitige Aufblinken zweier aufeinanderfolgender Leuchtdioden 3 signalisiert noch zusätzlich einen mittig zwischen den beiden blinkenden Leuchtdioden 3 liegenden Zwischenwert.

Ein konstantes Aufleuchten der elften Leuchtdiode 3 und ein simultanes impulsartiges Blinken der siebten und achten Leuchtdiode 3 in der zweiten Leuchtdiodenreihe 2 von links der Fig. 3 besagt, daß das dieser Farbzone zugeordnete Stellglied um den Wert 15/32 der Spanne von Leuchtdiode 3 zu Leuchtdiode 3 über den unteren Ansprechwert der achten Leuchtdiode 3 hinaus geöffnet ist.

Durch die Ansteuerung der sechzehn Leuchtdioden in der beschriebenen Weise können somit $16 \times 32 = 612$ Einzelstellungen des Stellgliedes angezeigt werden. Eine Anzeige mit derart großem Auflösungsgrad wird auch höchsten Güteanforderungen an die Farbqualität des Druckproduktes gerecht.

Die Erfindung ist natürlich keinesfalls auf die in den Figuren dargestellten und in der Beschreibung niedergelegten Ausführungsformen beschränkt, die lediglich als die Erfindung nicht begrenzende Beispiele anzusehen sind. Es versteht sich von selbst, daß auch andere Ausführungsformen mit zahlreichen Abwandlungen hinsichtlich baulicher Einzelheiten möglich sind, wie z.B. die Erhöhung der Ablesegenauigkeit durch Anzeige mehrerer Dezimalstellen. Ebensogut ist es denkbar, zur besseren Unterscheidung zwischen Grob- und Feinanzeige eine farbliche Abstimmung der Leuchtdioden 3 gegeneinander vorzusehen, wobei man zweckmäßigerweise auf handelsübliche Leucht-Elemente jeweils mit zwei Leuchtdioden Zurückgreift, die je nach Art der Ansteuerung unterschiedlich auf leuchten, z.B. die eine bei normaler Ansteuerung in roter Farbe, währenddessen die andere beim Ansteuern mit umgekehrter Stromflußrichtung grün aufleuchtet.

## Patentansprüche

1. Verfahren zum Anzeigen von Stellgrößen fernbedienter, zonaler Stellglieder zum Dosieren der Farb- und/oder Feuchtführung an einem zentralen Fernsteuerplatz einer Rotationsdruckmaschine, wobei die in Form von elektrischen Stellsignalen rüchgemeldeten Stellgrößen in Anzeigesignale umgewandelt und diese Signale zur optischen Darstellung des Farb- und/oder Feuchteprofils (7) jeweils den Leuchtdioden (3) von getrennten, den einzelnen Farb- und/oder Feuchtzonen zugeordneten Leuchtdiodenreihen (2) zugeführt werden, wobei jede der aufeinanderfolgenden leuchtdioden innerhalb einer Leuchtdiodenreihe einen anderen Anzeigewert repräsentiert, dadurch gekennzeichnet, daß aus denselben Stellsignalen die Anzeigesignale für eine Wertdarstellung in zwei wertmäßig unterteilten, jedoch räumlich identischen Anzeigen, von denen die eine als Grobanzeige und die andere als hochaufgelöste Feinanzeige dient, gewonnen werden, und zwar derart, daß alle jeweils innerhalb einer Leuchtdiodenreihe (2) aufeinanderfolgenden Leuchtdioden (3) nicht nur die verschiedenen Werte der Grobanzeige, sondern auch Zwischenwerte zwischen dem durch die betreffende Leuchtdiode aufgezeigten Wert der Grobanzeige und dem nächst höheren, nicht angezeigten Wert dieser Grobanzeige anzeigen, wobei jeder Leuchtdiode (3) dieser Reihe (2) ein anderer Zwischenwert zugeordnet ist.

2. Verhahren nach Anspruch 1, dadurch gekennzeichnet, daß die analoge Grobanzeige durch konstantes Aufleuchten und die digitale Feinanzeige gleichzeitig durch impulsartiges Blinken einer einzelnen oder gleichzeitig jeweils zweier aufeinanderfolgender Leuchtdioden (3) einer Leuchtdiodenreihe (2) erfolgt.

3. Verfahren nach Anspruch 1 oder 2, dadurch gekennzeichnet, daß ein Wertungsschritt der Grobanzeige von einer der Leuchtdioden (3) zur nächstfolgenden Leuchtdiode (3) jeweils einer Leuchtdiodenreihe (2) in so viele Feinwerte unterteilt ist, wie insgesamt Leuchtdioden (3) in einer Leuchtdiodenreihe (2) der Grobanzeige vorhanden sind.

4. Verfahren nach einem oder mehreren der vorangehenden Ansprüche, dadurch gekennzeichnet, daß zur Feinanzeige die Zwischenwerte dezimal auf die Leuchtdioden (3) einer zonalen Leuchtdiodenreihe (2) aufgeteilt sind.

5. Verfahren nach einem oder mehreren der vorangehenden Ansprüche, dadurch gekennzeichnet, daß zur Erhöung des Auflösungsvermögens der Feinanzeige gleichzeitig mehrere aufeinanderfolgende Leuchtdioden (3) einer leuchtdiodenreihe (2) ansteuerbar sind.

## Revendications

1. Procédé pour l'affichage de grandeurs de réglage d'organes de réglage zonaux télécommandés pour le dosage de l'application d'encre et/ou d'eau de mouillage à un poste de télécommande central d'une machine d'impression rotative, les grandeurs de réglage renvoyées sous la forme de signaux de réglage électriques étant transformées en signaux d'affichage et ces signaux étant envoyés pour la représentation optique du profil d'encrage (7) et/ou de mouillage aux diodes (3) électroluminescentes de rangées de diodes électroluminescentes séparées, associées aux dif-

férentes zones d'encrage et/ou de mouillage, chacune des diodes électro-luminescentes successives à l'intérieur d'une rangée de diodes électro-luminescentes représentant une autre valeur d'affichage, caractérisé en ce que à partir des mêmes signaux de réglage, on tire les signaux d'affichage pour une représentation de valeur en deux affichages identiques, divisés en ce qui concerne la valeur mais identiques dans l'espace, dont l'un sert d'affichage grossier et l'autre d'affichage fin à haute résolution à ceci par le fait que toutes les diodes électro-luminescentes (3) qui se suivent à l'intérieur d'une même rangée de diodes électro-luminescentes (2) indiquent non seulement les différentes valeurs de l'affichage grossier mais également des valeurs intermédiaires entre la valeur de l'affichage grossier représenté par la diode électro-luminescente correspondante et la valeur immédiatement supérieure, non affichée de cet affichage grossier, une autre valeur intermédiaire étant associée à chaque diode électro-luminescente (3) de cette rangée (2).

2. Procédé suivant la revendication 1, caractérisé en ce que l'affichage analogique grossier se produit par éclairage constant et l'affichage numérique fin simultanément, par clignotement par impulsions d'une seule ou simultanément de deux diodes électro-luminescentes (3) successives d'une rangée (2) de diodes électro-luminescentes.

3. Procédé suivant la revendication 1 ou 2, caractérisé en ce qu'un pas d'évaluation de l'affichage grossier de l'une des diodes électro-luminescentes (3) de la diode électro-luminescente (3) immédiatement suivante d'une rangée (2) de diodes électro-luminescentes est subdivisé en un nombre de valeurs fines égales au nombre total de diodes électro-luminescentes contenues dans une rangée (2) de diodes électro-luminescentes de l'affichage grossier.

4. Procédé suivant une ou plusieurs des revendications précédentes, caractérisé en ce que pour l'affichage fin, les valeurs intermédiaires sont divisées de façon décimale en les diodes électro-luminescentes (3) d'une rangée zonale (2) de diodes électro-luminescentes (3).

5. Procédé suivant une ou plusieurs des revendications précédentes, caractérisé, en ce que, pour améliorer le pouvoir de résolution de l'affichage fin, plusieurs diodes électro-luminescentes successives (3) d'une rangée (2) de diodes électro-luminescentes peuvent être excitées simultanément.

**Claims**

1. A method for indicating the adjustments of remote-controlled zone-by-zone adjustment parts for dosing the supply of ink and/or dampening solution, at a central remote-control desk of a rotary printing press, in which the adjustments, fed-back in the form of electrical adjusting signals, are changed into indication signals and these signals, for tne purpose of optically indicating the ink and/or dampening profile (7) are fed to separate LED's (3) of separate rows (2) of LED's for the separate ink and/or dampening solution zones, each of the LED's, placed one after the other within such a row, being representative of a different indication value, characterized in that from the same adjusting signals the indication signals are produced for giving a representation of one value in two indications, valuably subdivided but spatially identical, the one of said indication being used as a coarse indication and the other as a high-resolution indication, such that all LED's (3) placed one after the other within one LED row (2) are used for indicating not only the different values of the coarse indication but furthermore for the subdivided high-resoluted values between the coarse value visuably actuated momently and the next higher not indicated coarse value, each LED (3) of this row (2) being twice used, first for the coarse values and second used for the intermediate values between the coarse values.

2. A method as claimed in claim 1, characterized in that the analog coarse indication is produced by steady lighting up, and the digital high reolution indication is produced by an impulse-like flashing of a single LED (3) or instead of. two LED's within a row (2) of LED's simultaneously.

3. A method as claimed in claim 1 or claim 2, characterized in that one value step of the coarse indication between two successive LED's (3) of one row (2) of LED's is subdivided into a number of high-resolution values, which number corresponds to the number of all LED's (3) in that row of LED's in the coarse indication.

4. A method as claimed in any one of claims 1 to 3, characterized by a decimal subdivision of the intermediate values over the LED's (3) of the row (2) corresponding to each ink zone for purpose of high-resolution indication.

5. A method as claimed in any one of claims 1 to 4, characterized by actuating several successive LED's (3) of a row (2) of LED's simultaneously for increasing the degree of resolution of the high resolution indication.

Fig. 1

Fig. 2

16
15
14
13
12
11
10
9
8
7
6
5
4
3
2
1

3

2

4

7

1

5

+   +   +   +

−   −   −   −

0 007 009

Fig. 3